# EUROPEAN PATENT SPECIFICATION

(11) **EP 2 065 808 B1**
(45) Date of publication and mention of the grant of the patent: **20.10.2010**
(21) Application number: 09155014.5
(22) Date of filing: 06.08.2004
(51) Int. Cl.: G06F 15/78, G06F 13/16, G06F 13/28, G06F 15/17

(54) **Processor integrated circuit comprising a plurality of processors having local memories and means for synchronising DMA accesses to these memories**
Integrierte Prozessorschaltung mit mehreren Prozessoren welche lokale Speicher haben sowie Mittel um DMA-Zugriffe auf diese Speicher zu synchronisieren
Circuit intégré processeur comprenant une pluralité de processeurs ayant des mémoires locales et des moyens pour la synchronisation des accès DMA à ces mémoires

(30) Priority: 07.08.2003 JP 2003289410
(43) Date of publication of application: 03.06.2009
(62) Divisional of application: 04771636.0
(73) Proprietor: Panasonic Corporation, Kadoma-shi Osaka 571-8501 (JP)
(72) Inventor: Hirano, Takehisa, Osaka-shi Osaka 540-6207 (JP); Nakai, Katsuhiro, Osaka-shi Osaka 540-6207 (JP); Tezuka, Tomoaki, Osaka-shi Osaka 540-6207 (JP); Mukai, Kouji, Osaka-shi Osaka 540-6207 (JP)
(74) Representative: Eisenführ, Speiser & Partner

(56) References cited:
- US-A- 5 724 583
- US-A- 5 748 945
- US-A1- 2002 059 393
- US-A1- 2002 095 609
- US-B1- 6 415 345

## Description

### TECHNICAL FIELD

The present invention relates to a processor integrated circuit, and a product development method equipped with the processor integrated circuit. More particularly, the invention relates to a processor integrated circuit using processors which are operated by programs, and a product development method equipped with the processor integrated circuit.

### BACKGROUND ART

In recent years, multimedia has begun to spread among home consumers, and demands for speeding-up of processors performing video and audio processings have increased. In order to realize speeding-up of processors, there is generally employed a technique of increasing a processor operation clock frequency by increasing the number of pipelines.

However, when a change is made to hardware of a processor, such as an increase in the number of pipelines, in order to increase the processor operation clock frequency, a program which has been used stops functioning correctly. Therefore, as a conventional processor system, Japanese Published Patent Application No. 2000-29696 (Page 13, Figures 10, 11, and 12) proposes a processor system in which a hardware NOP (Non Operation) is inserted in order to execute a program which is developed for processors having different numbers of pipelines, with more stages of pipeline processings. Alternatively, Japanese Published Patent Application No. 2002-32218 (Page 6, Figures 1, 2, 3) proposes a processor system in which both of securing in program compatibility and speeding-up are achieved using plural processors of different architectures.

US 5,748,945 discloses a method for providing slave direct memory access (DMA) support on a computer system bus that does not support slave devices, such as the personal computer interconnect or "PCI"' bus. Using the method, an adapter card or microprocessor with a local DMA controller can be operated as a busmaster and simulate a system DMA controller which would normally be used during slave DMA operations. Alternatively, the method allows a local DMA controller to work with an existing system DMA controller so that application software receives the correct status when polling registers in the system DMA controller. The method allows the system DMA controller to operate as if the system DMA controller is controlling DMA transfers. In this way device contention between the system DMA controller and the local DMA controller is avoided.

A multiprocessor apparatus according to US 2002/0095609 A1 includes a high speed processor coupled to a high speed bus, a low speed processor coupled to a low speed bus, a bus adapter for coupling between the high speed bus and the low speed bus, an operating system for determining as to at which processor application program is to be executed, and an activation controller for activating clock signal for the processor which executes the application program, based on the determination result of the operating system.

US 2002/059393 discloses a chip multiprocessor, wherein each processor has local memory. A host processor is able to access the local memories via DMA controllers in the chip multiprocessor.

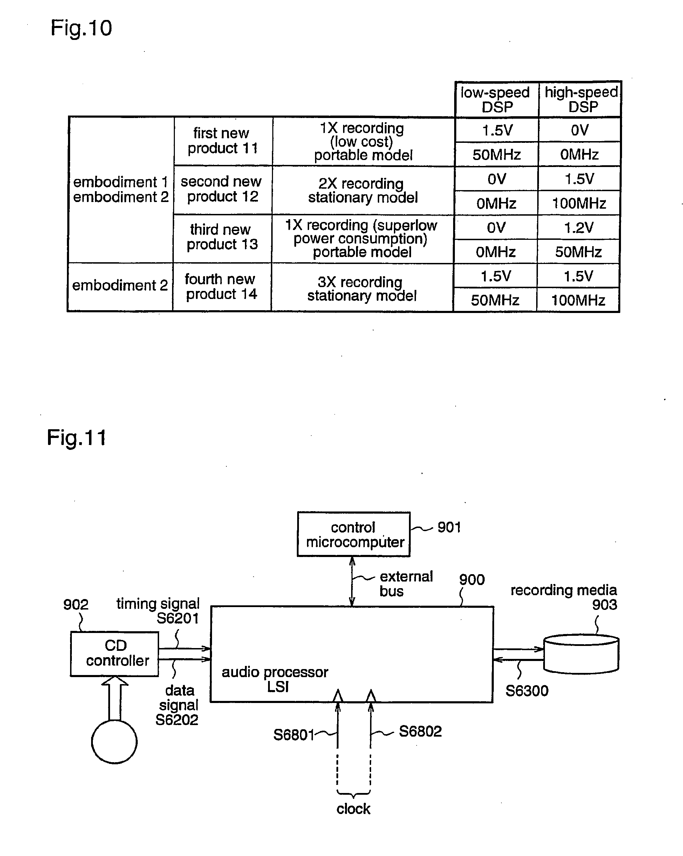

Figure 11 is a block diagram illustrating an audio product.

Initially, a description will be given of an audio recording operation for compressing music data on a CD, and compressively recording the data on a recording media, with reference to figure 11.

In figure 11, the audio product comprises an audio processor LSI 900 performing data compression, a control microcomputer 901 for controlling the audio processor LSI 900, a CD controller 902 for performing data reading from a CD, and a recording media 903 in which compressed data are stored.

The CD controller 902 reads music data from the CD, and outputs an audio data signal S6202 as well as a timing signal S6201 to the processor LSI 900.

The processor LSI 900 is a digital signal processor to be described later (hereinafter referred to as DSP), which compresses the audio data signal S6202 and records the compressed signal in the recording media 903.

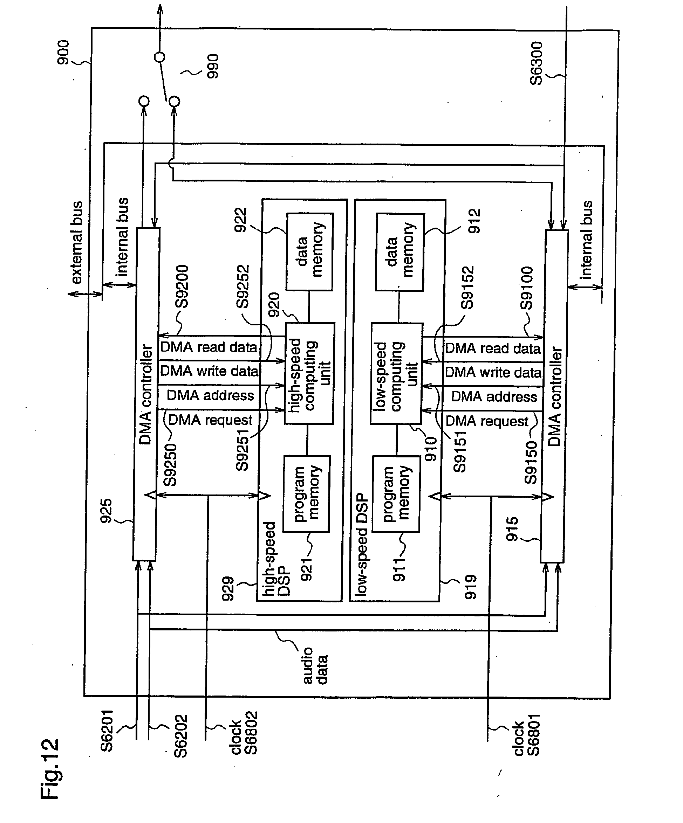

Figure 12 is a diagram illustrating the internal construction of the conventional processor integrated circuit 900.

With reference to figure 12, a low-speed computing unit 910 is capable of operation up to 50MHz, and a high-speed computing unit 920 is capable of 100MHz operation. The high-speed computing unit 920 is obtained by increasing the number of stages of pipeline processings from that of the low-speed computing unit 910 to realize 100MHz operation, and there is no program compatibility between the low-speed computing unit 910 and the high-speed computing unit 920.

The low-speed computing unit 910 is connected to a program memory 911 and to a data memory 912, and performs compressive recording by a special program stored in the program memory 911. The processing result is stored in the data memory 912. Thus, a low-speed DSP 919 is obtained by combining the computing unit 910, the program memory 911, and the data memory 912.

The low-speed DSP 919 and the outside of the processor LSI 900 are connected through a DMA controller 915. The DMA controller 915 arbitrates an internal bus access request from the control microcomputer 901 or the like, an audio data writing request from the CD controller 902 by the timing signal S6201, and a data reading request S6300 from the recording media 903, and performs DMA (Direct Memory Access) through the low-speed computing unit 910.

Likewise, the high-speed DSP 929 comprises a high-speed computing unit 920, a program memory 921, and a data memory 922, and is connected to the outside of the LSI through a DMA controller 925. The DMA controller 925 also arbitrates access requests from the outside of the LSI, like the DMA controller 915.

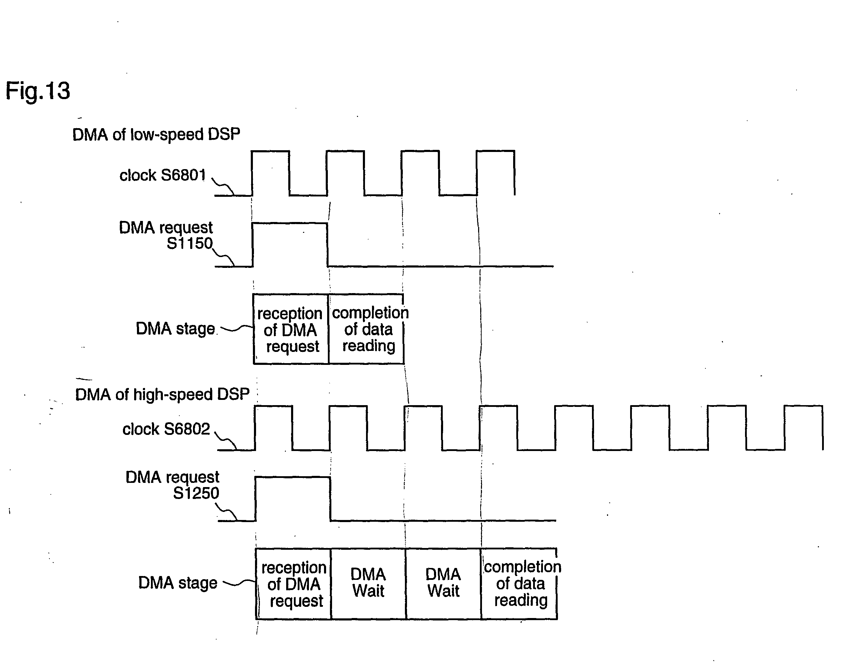

Figure 13 shows a DMA timing chart of the conventional low-speed DSP 919, and a DMA timing chart of the conventional high-speed DSP 929.

With reference to figure 13, the low-speed DSP 919 outputs a DMA read signal S9100 by one clock after a DMA request, while the high-speed DSP 929 outputs a DMA read signal S9200 by three clocks after a DMA request. That is, the latency of the DMA of the low-speed DSP 919 is one clock, and that of the high-speed DSP 929 is three clocks.

Accordingly, the low-speed DSP DMA controller 915 operates so as to capture data at the next clock after issue of the DMA. request, while the high-speed DSP DMA controller 925 operates so as to capture data at the third clock after issue of the DMA. request.

Using the processor LSI 900 constructed as described above, the different two DSPs are selectively used according to the contests of processing to be carried out.

For example, it is assumed that a clock frequency of 50MHz is required for 1X-speed recording. When performing 1X-speed recording, compressive recording is carried out using the low-speed DSP 919. However, when performing 2X-speed recording, a clock frequency of 100MHz is required. However, the low-speed DSP 919 cannot operate at 100MHz. Therefore, compressive recording is carried out by the high-speed DSP 929, and the output selector 990 is controlled to record the output of the high-speed DSP 929 on the recording media 903.

However, when achieving both of program compatibility and speeding-up of the processor integrated circuit, the construction with a hardware NOP being inserted as disclosed in Japanese Published Patent Application No. 2000-29696 has a drawback that the number of logic circuits and the number of program steps undesirably increase due to addition of a NOP command (delay command) by hardware, resulting in an increase in power consumption.

Further, in the construction using plural processors as disclosed in Japanese Published Patent Application No. 2002-32218 or the conventional construction shown in figure 12, since plural processors are used, the circuit scale, especially the memory amount, increases. Further, since two or more processors of different architectures are used, at least two kinds of control circuits are needed in the vicinity of the processors, resulting in an increase in man-hour for hardware designing, particularly, an increase in man-hour for designing DMA controllers.

The present invention is made to solve the above-mentioned problems and has for its object to provide a processor integrated circuit that can achieve both of securing in program compatibility and speeding-up, without increasing the scales of hardware and software, man-hour for designing and power consumption.

### DISCLOSURE OF THE INVENTION

In order to solve the above-mentioned problems, a processor integrated circuit according to Claim 1 of the present invention is proposed.

Accordingly, the respective DMA arbitration circuits can be made identical to each other, and only one kind of control circuit is required in the vicinity of the processors, leading to a reduction in man-hour for hardware designing.

### BRIEF DESCRIPTION OF THE DRAWINGS

Figure 1 is a block diagram illustrating a processor integrated circuit according to an example useful for understanding the invention.
Figure 2 is a block diagram illustrating a processor integrated circuit according to a second embodiment of the present invention.
Figure 3 is a block diagram illustrating a processor integrated circuit including peripheral circuits of a low-speed DSP and a high-speed DSP shown in figure 2.
Figure 4 shows timing charts for explaining the operations of the low-speed DSP and high-speed DSP according to a second embodiment of the present invention.
Figure 5 is a diagram illustrating the processor integrated circuit shown in figure 3 which is provided with a frequency division circuit.
Figure 6 shows timing charts of DMAs of the low-speed DSP and high-speed DSP according to the second embodiment of the present invention.
Figure 7 shows timing charts of DMA pipelines of the low-speed DSP and high-speed DSP according to the second embodiment of the present invention.
Figure 8 is a diagram illustrating the processor integrated circuit shown in figure 2, which is provided with two low-speed DSPs and two high-speed DSPs.
Figure 9 is a flow chart of audio product development according to an example useful for understanding the present invention.
Figure 10 is a diagram illustrating operating modes of DSPs in plural products according to an example useful for understanding the present invention.
Figure 11 is a block diagram of an audio product.
Figure 12 is a block diagram of the conventional processor integrated circuit.
Figure 13 shows timing charts of DMAs of the conventional low-speed DSP and high-speed DSP.

### BEST MODE TO EXECUTE THE INVENTION

Hereinafter, embodiments and examples of the present invention will be described with reference to the drawings.

### Example 1

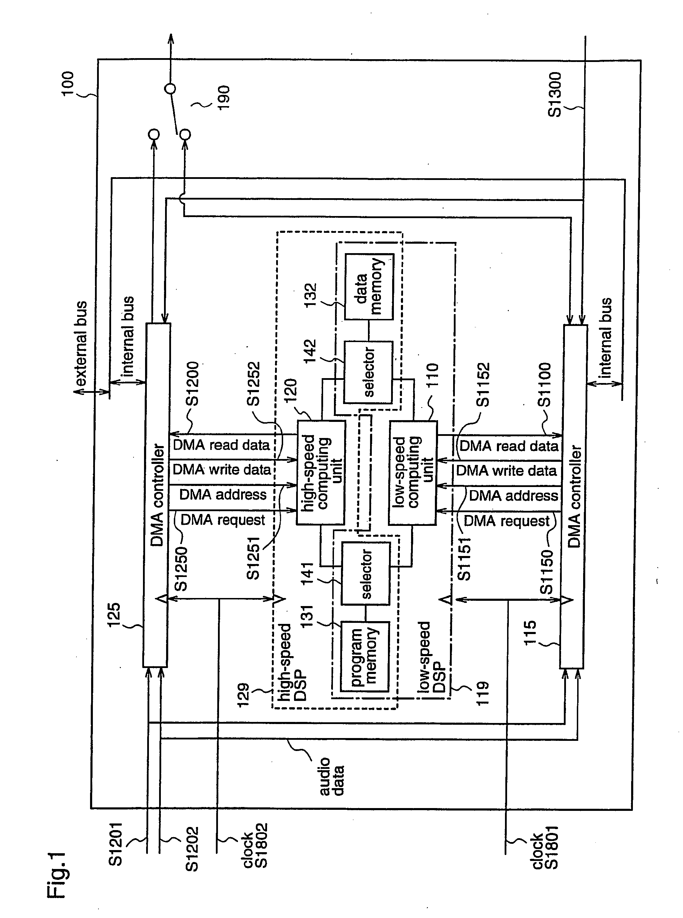

Figure 1 is a diagram illustrating an internal construction of a processor integrated circuit 100 according to a first example of the present invention.

With reference to figure 1, the processor integrated circuit 100 comprises a low-speed computing unit 110 capable of operating up to 50MHz and a high-speed computing unit 120 capable of operating up to 100MHz which are included in a computing unit group; a program memory 131 as a first storage unit in which a program for operating the low-speed computing unit 110 or the high-speed computing unit 120 is stored; a data memory (second storage unit) 132 as a memory area to be used for computation by the low-speed computing unit 110 or the high-speed computing unit 120; a computing unit selector 141 as a first connection switching unit for connecting the low-speed computing unit 110 or the high-speed computing unit 120 which performs computation with the data memory 132; a low-speed DSP DMA controller 115 as a DMA arbitration circuit for arbitrating, when the low-speed computing unit 110 is used as a low-speed DSP (Digital Signal Processor) 119, accesses to the low-speed DSP, thereby to perform DMA (Direct Memory Access); and a high-speed DSP DMA controller 125 as a DMA arbitration circuit for arbitrating, when the high-speed computing unit 120 is used as a high-speed DSP 129, accesses to the high-speed DSP, thereby to perform DMA.

The low-speed DSP 119 comprises the low-speed computing unit 110, the program memory 131 as the first storage unit, and the data memory 132 as the second storage unit, while the high-speed DSP 129 comprises the high-speed computing unit 120, the program memory 131 as the first storage unit, and the data memory 132 as the second storage unit. The processor integrated circuit 100 according to the first example employs the low-speed computing unit 110 as a computing unit which is operated with a program having usage track records, and the high-speed computing unit 120 as a computing unit having processing capability higher than that of the low-speed computing unit 110. The power consumption of the low-speed computing unit 110 is lower than that of the high-speed computing unit 120.

As described above, the processor integrated circuit according to the first example of the present invention performs computations by the low-speed computing unit 110 and the high-speed computing unit 120 having different processing capabilities and different power consumptions, with the program memory 131 and the data memory 132 being shared between these computing units.

When the processor integrated circuit is used as the low-speed DSP 119, the low-speed computing unit 110 is connected to the program memory 131 and the data memory 132 by the computing unit selectors 141 and 142, respectively, and performs compressive recording by the exclusive program stored in the program memory 131. The processing result is stored in the data memory 132. Likewise, when the processor integrated circuit is used as the high-speed DSP 129, the high-speed computing unit 120 is connected to the program memory 131 and the data memory 132 by the computing unit selectors 141 and 142, and performs compressive recording by the exclusive program stored in the program memory 131. The processing result is stored in the data memory 132.

Further, the computing unit selector 141 as the first connection switching unit selects either the low-speed computing unit 110 or the high-speed computing unit 120 as a unit to be connected to the program memory 131, according to the program stored in the program memory 131. Further, the computing unit selector 142 as the second connection switching unit selects either the low-speed computing unit 110 or the high-speed computing unit 120 which is operated by the program stored in the program memory 131, as a unit to be connected to the data memory 132.

More specifically, the low-speed DSP 119 and the high-speed DSP 129 are different from the conventional DSPs 919 and 929 in that the memories and the computing units are separated from the conventional DSPs 919 and 929 shown in figure 12, and the memories are shared by the computing units.

Further, the low-speed DSP 119 and the outside of the processor integrated circuit 100 are connected through the DMA. controller 115. The DMA controller 115 arbitrates an internal bus access request from a control microcomputer (not shown), an audio data writing request from a CD controller (not shown) by a timing signal S1201, and a data reading request S1300 from a recording media (not shown), and performs DMA through the low-speed computing unit 110.

The high-speed DSP 129 is also connected to the outside of the LSI through the DMA controller 125. The DMA controller 125 also arbitrates the access requests from the outside of the LSI, which are identical to those supplied to the DMA controller 115.

The processor integrated circuit according to the first example of the present invention is constructed such that computations by the low-speed computing unit 110 and the high-speed computing unit 120 are carried out with the program memory 131 and the data memory 132 being shared between these computing units. When the processor integrated circuit is used as the low-speed DSP 119, the program for the low-speed computing unit 110 is stored in the program memory 131, and the computing unit selectors 141 and 142 are switched to the low-speed computing unit side, whereby the processor integrated circuit can perform the same operation as the low-speed computing unit with the program identical to the program having usage track records. On the other hand, when the processor integrated circuit is used as the high-speed DSP 129 having processing capability higher than that of the low-speed DSP 119, the program of the high-speed computing unit is stored in the program memory 131, and the computing unit selectors 141 and 142 are switched to the high-speed computing unit side, whereby the processor integrated circuit can perform high-speed operation. Therefore, it is possible to provide a processor integrated circuit which can reduce the number of memories by half, and can achieve both of ensuring of program compatibility and speeding-up without increasing the circuit scale and power consumption.

Further, since, in recent AV equipment, data compression techniques such as MPEG are heavily used and large-scale memories are mounted, a greater part of cost is occupied not by random logics but by memories. However, in the above-mentioned construction, the data memory and the program memory which occupy a greater part of cost can be reduced, resulting in a low-cost processor integrated circuit.

While the processor integrated circuit according to the first example of the present invention employs a computing unit group comprising two kinds of, i.e., low-speed and high-speed, computing units, the present invention is not restricted thereto. The present invention is also effective even when using a computing unit group comprising n (n: natural number not less than 2) pieces of computing units in which at least one computing unit has a different architecture. Further, the n pieces of computing units may be of the same type.

While in this first example the program having usage track records is employed as a program for the low-speed computing unit, the present invention is not restricted thereto, and a new program may be employed as a program for the low-speed computing unit.

### (Embodiment 2)

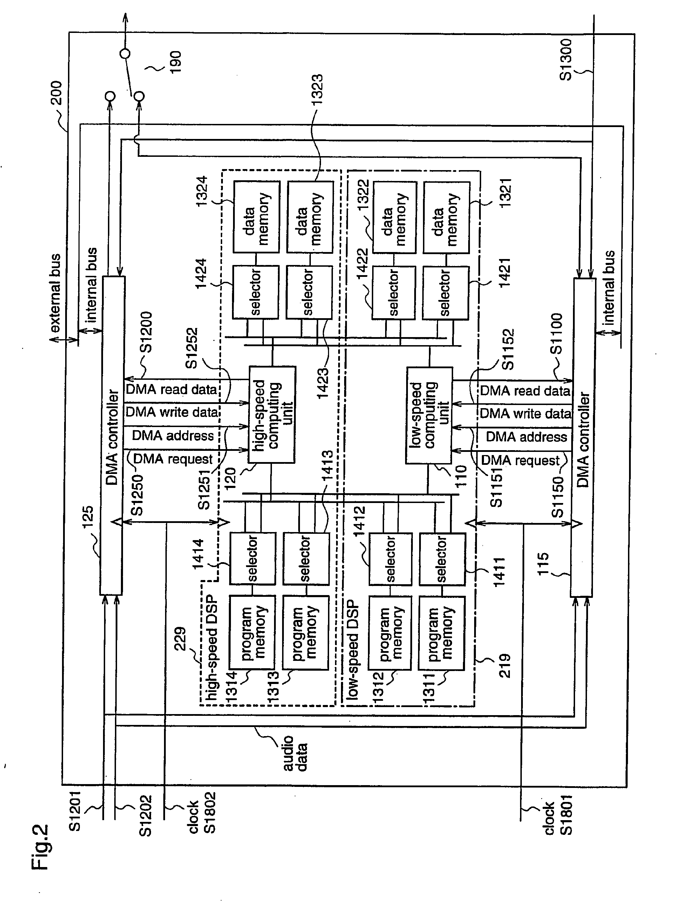

Figure 2 is a diagram illustrating an internal construction of a processor integrated circuit 200 according to a second embodiment of the present invention.

The constituents which operate in the same manners as those shown in figure 1 are given the same reference numerals, and descriptions thereof will be omitted.

With reference to figure 2, a first storage unit of the processor integrated circuit according to the second embodiment has program memories 1311, 1312, 1313, and 1314 was four memory areas, and these program memories are obtained by dividing the program memory 131 as the first storage unit of the first example into four modules. Further, a second storage unit has data memories 1321, 1322, 1323, and 1324 as four memory areas, and these data memories are obtained by dividing the data memory 132 as the second storage unit of the first example into four modules.

Computing unit selectors 1411, 1412, 1413, and 1414 as first connection switching units are individually provided for the respective modules so that connection with a computing unit that performs computation can be selected for each of the four modules of the divided program memories, and these selectors correspond to the computing unit selector 141 as the first connection switching unit of the first example. Likewise, computing unit selectors 1421, 1422, 1423, and 1424 as second connection switching units are also individually provided for the respective modules so that the connection with the computing unit that performs computation can be selected for each of the four modules of the data memories, and these selectors correspond to the computing unit selector 142 as the second connection switching unit of the first example.

In this construction, the same operation as described for the first example can be realized by switching all of the program memories 1311, 1312, 1313, and 1314 or the data memories 1321, 1322, 1323, and 1324 in conjunction with each other. Further, when the program memories 1311 and 1312 and the data memories 1321 and 1322 are connected to the low-speed computing unit 110 while the program memories 1313 and 1314 and the data memories 1323 and 1324 are connected to the high-speed computing unit 120, parallel computations can be achieved by the two processors, i.e., the low-speed DSP 219 and the high-speed DSP 229.

For example, the compressive recording program described for the background art is divided into two programs of "audio compression" and "recording determination", and the audio compression program is changed to that for the high-speed computing unit 120. At this time, the program of "recording determination" is downloaded to the program memories 1311 and 1312 corresponding to the low-speed DSP 219, while the program of "audio compression" is downloaded to the program memories 1313 and 1314 corresponding to the high-speed DSP 229. In stead of individually downloading the programs, for example, the programs of "recording determination" and "audio compression" are downloaded simultaneously and collectively to the program memories 1311, 1312, 1313, and 1314, and when executing parallel computation, the respective program memories in which the program of "recording determination" is stored are connected to the low-speed computing unit 110 while the respective program memories in which the program of "audio compression" is stored are connected to the high-speed computing unit 120, using the computing unit selectors 1411, 1412, 1413, and 1414. Thereby, the program downloading procedure can be done at one time.

As described above, the program of "recording determination" by digital watermark detection is stored in the program memories 1311 and 1312. The low-speed DSP 119 performs detection of information as to "whether recording is permitted or not" which is embedded as a digital watermark in inputted audio data, using the data memories 1321 and 1322, according to the program of "recording determination".

Then, the program of "audio compression" is stored in the program memories 1313 and 1314. The high-speed DSP 229 performs compression of inputted audio data using the data memories 1323 and 1324, according to the program of "audio compression". The high-speed DSP 229 reads the information detected by the low-speed DSP 219, and when recording is permitted, the DSP 229 records the data compressed by the compression program into the recording media (not shown). In this way, since the low-speed DSP 219 operating at 50MHz and the high-speed DSP 229 operating at 100MHz perform parallel computations, processing capability equivalent to 150MHz is obtained, and the recording function can deal with up to 3X-speed.

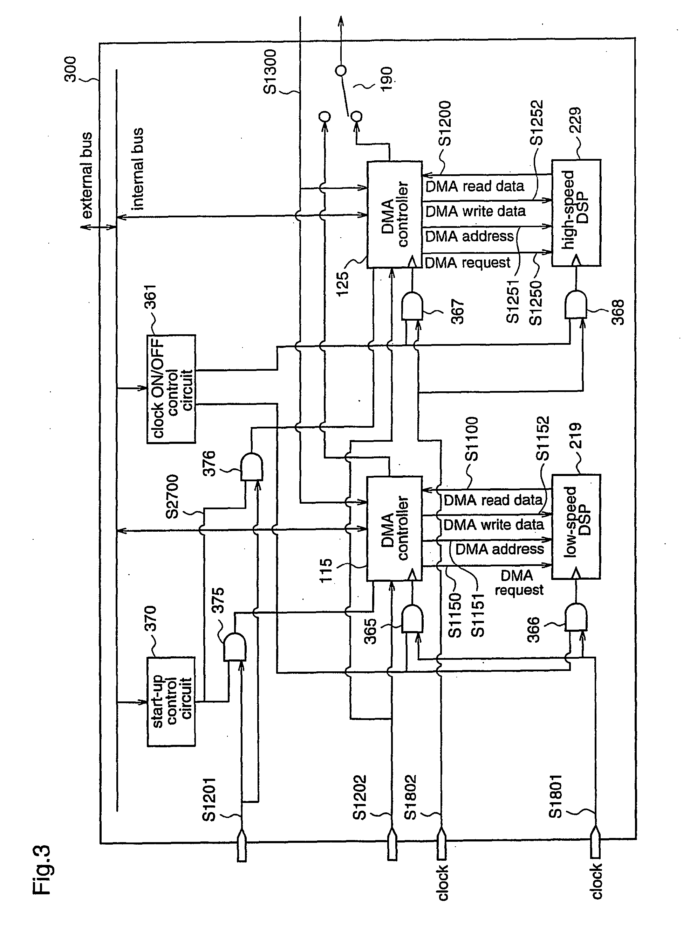

Next, a description will be given of peripheral circuits of the two DSPs according to the second embodiment, with reference to figure 3.

Figure 3 is a diagram illustrating a processor integrated circuit 300 including peripheral circuits of the low-speed DSP 219 and the high-speed DSP 229 shown in figure 2, wherein the same constituents as those shown in figures 1 and 2 are given the same reference numerals, and descriptions thereof will be omitted.

In figure 3, the processor integrated circuit 300 is provided with clock gates 365, 366, 367, and 368, and these clock gates control ON/OFF of clocks supplied to the low-speed DSP DMA controller 115, the low-speed DSP 219, the high-speed DSP DMA controller 125, and the high-speed DSP 229, respectively, according to setting of a clock ON/OFF control circuit 361 by the control microcomputer (not shown).

In this construction, when using only the low-speed computing unit 110, the clocks supplied to the high-speed DSP 229 and the high-speed DSP DMA controller 125 are stopped. Conversely, when using only the high-speed computing unit 120, the clocks supplied to the low-speed DSP 219 and the low-speed DSP DMA controller 115 are stopped. Thereby, power consumption does not increase when the conventional program which uses the low-speed computing unit 110 is operated. On the other hand, all the clocks are turned ON when parallel computations are carried out using both of the low-speed computing unit 110 and the high-speed computing unit 120.

While in this second embodiment the clocks are stopped using the clock gates for stopping the clocks, the power may be cut off instead of stopping the clocks. It is needless to say that the same effects as mentioned above can be achieved when the processor integrated circuit shown in figure 1 or 10 adopts the same construction as the second embodiment.

Further, in figure 3, timing signal gates 375 and 376 are controlled by a start-up signal S2700 supplied from a start-up control circuit 370, and these gates control a timing signal S1201 outputted from the CD controller (not shown) according to setting by the control microcomputer (not shown).

At this time, the low-speed DSP DMA controller 115 and the high-speed DSP DMA controller 125 capture an audio data signal S1202 at the both edges of the timing signal S1201 which is the same control signal controlled by the timing signal gates 375 and 376, and perform DMA write access to the data memory in the DSP.

As described with reference to figure 2, the recording function is divided into "audio compression" and "recording determination" using digital watermark detection, and the input audio data taken into the data memory is subjected to parallel computations by the low-speed DSP 219 and the high-speed DSA 229. The low-speed DSP 219 adopts a frame period corresponding to four samples, detects digital watermark information included in the audio data for each frame, and outputs the detected information to the data memory 1321. The high-speed DSP 229 adopts a frame period corresponding to eight samples, and compresses the audio data on the data memory for each frame. As described above, in the processor integrated circuit according to the second embodiment, the ratio of the processing units of the low-speed DSP 219 and the high-speed DSP 229 is set to "1:2" sample, whereby the ratio of program periods of the high-speed DSP and the low-speed DSP is set to "1:2", thereby to synchronize the respective DSPs.

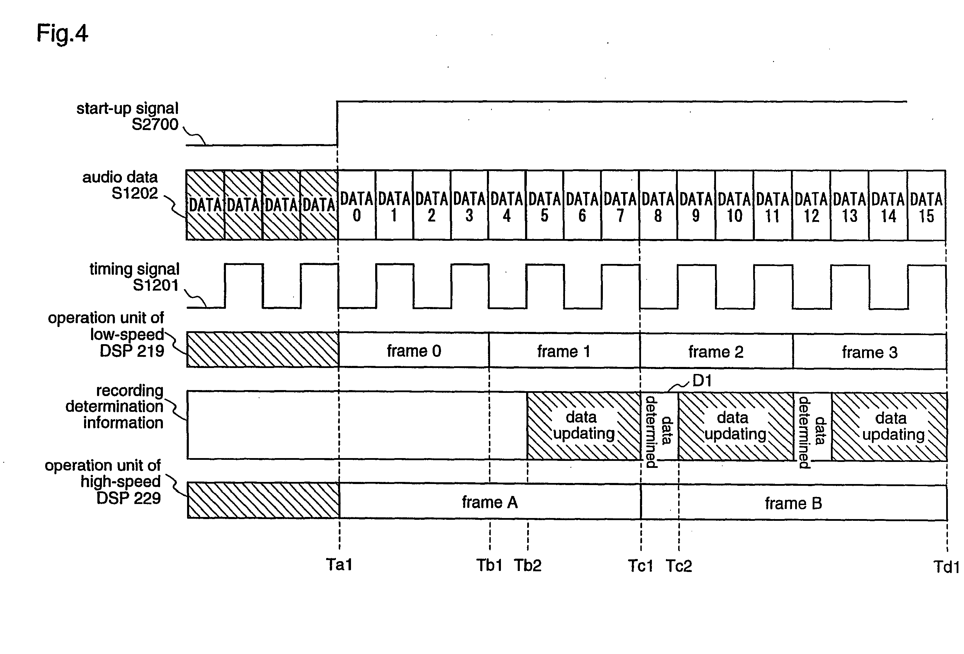

Next, a description will be given of the operations of the low-speed DSP 219 and the high-speed DSP 229 which are timing-controlled by the start-up control circuit 370 shown in figure 3, with reference to figure 4.

Figure 4 is a timing chart illustrating synchronization relationship between the low-speed DSP 219 and the high-speed DSP 229 in the processor integrated circuit according to the second embodiment of the present invention. The control microcomputer (not shown) checks that the both DSPs are in their operation-ready states, and releases the timing signal gates 375 and 376 at time Ta1 using the start-up control circuit 370. The low-speed DSP 219 and the high-speed DSP 229 simultaneously starts to download the audio data signal S1201 from time Ta1 into the data memory by the DMA controller according to the same control signal.

Initially, at time Tb1, the low-speed DSP 219 starts detection of a digital watermark included in frame 0, and starts, from time Tb2, updation of old recording determination information on the data memory 1321, and completes updation of information D1 at time Tc1. Thereafter, the low-speed DSP 219 repeats the above-mentioned operation at four-sample period.

At time Tc1 the high-speed DSP 229 reads the recording determination information D1 that is detected by the low-speed DSP 219. When the recording determination information D1 is recordable, the high-speed DSP 229 starts compression of the audio data included in frame A, and completes the processing by time Td1. Thereafter, the high-speed DSP 229 repeats the above-mentioned at eight-sample period.

A point to be noticed is that time Tb2 to Tc1 is a period during which the recording determination information outputted from the low-speed DSP 219 is being updated, and therefore, no information is determined in this period.

In this second embodiment, since frame start (time Tc1, Td1) of the high-speed DSP 229 is synchronized with frame start of the low-speed DSP 219 by simultaneously releasing the timing signal gates 375 and 376, the high-speed DSP 229 does not read the data being updated, at the head (time Tc1, Td1) of each frame.

In this way, the low-speed DSP and the high-speed DSP are synchronized using the "1:2" sample which is the ratio of processing units for input/output data of these DSPs, as the ratio of program periods of the two DSPs, and therefore, it is possible to read the defined "recording determination information" without increasing the burden of program processing such as handshake processing.

While in this second embodiment the data processing unit of each DSP is "1:2", the present invention is not restricted thereto. The present invention is also effect even when "1:N" sample is used as the ratio of program periods of the respective DSPs.

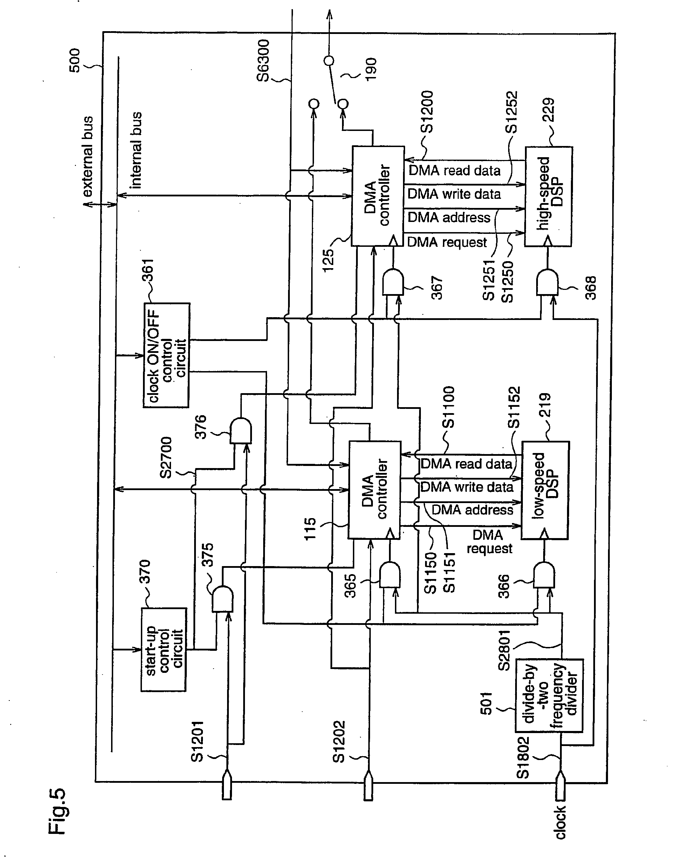

Next, a description will be given of an example of a processor integrated circuit which reduces the man-hour in designing the DMA controller, with reference to figures 5 to 7.

Figure 5 is a diagram illustrating the processor integrated circuit described with reference to figure 3, which is provided with a divide-by-two frequency divider 501.

In figure 5, the divide-by-two frequency divider 501 supplies a clock S2801 having a frequency that is 1/2 of the frequency of an inputted clock S1802, to the low-speed DSP DMA controller 115, the low-speed DSP 219, and the high-speed DSP DMA controller 125. On the other hand, the clock S1802 before division is supplied to the high-speed DSP 229. A difference from the conventional processor integrated circuit 900 is that the ratio of clock frequencies of the clock supplied to the high-speed DSP DMA controller 125 and the clock supplied to the high-speed DSP 229 is "1:2".

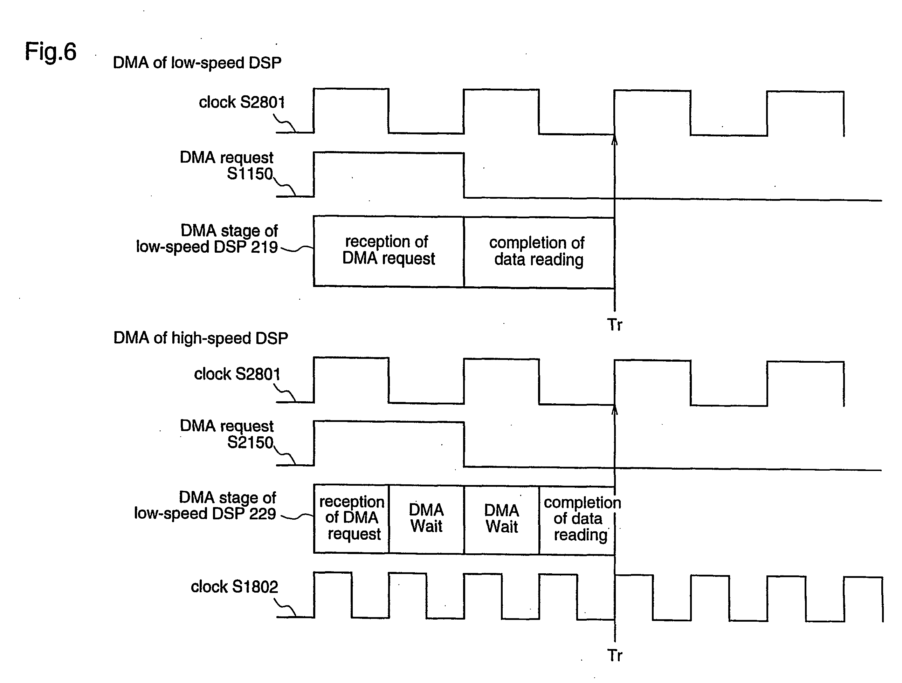

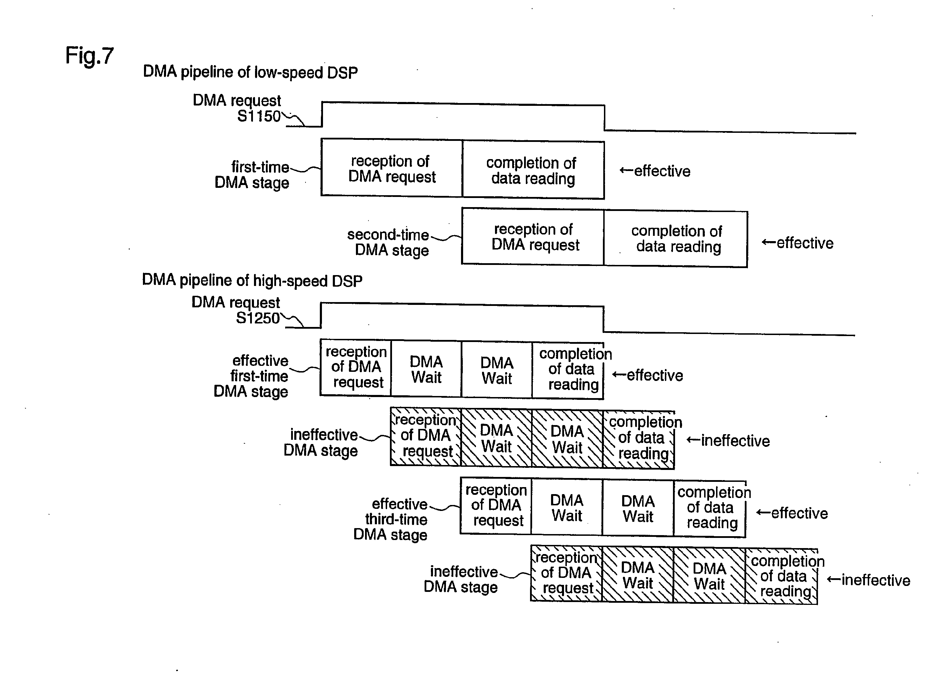

Further, figure 6 is a timing chart illustrating DMA accesses of the low-speed DSP 219 and the high-speed DSP 229, and figure 7 is a timing chart illustrating pipeline operations of the low-speed DSP 219 and the high-speed DSP 229 when DMA requests are continued.

Since the low-speed DSP 219 and the high-speed DSP 229 having different numbers of internal pipelines as described with reference to figure 13, the latency of the DMA of the low-speed DSP 219 corresponds to one clock while the latency of the DMA of the high-speed DSP 229 corresponds to three clocks. Since the DMA of the low-speed DSP 219 shown in figure 6 is completely identical to the DMA of the low-speed DSP shown in figure 13, description thereof will be omitted.

The DMA of the high-speed DSP 229 shown in figure 6 is different from the DMA of the high-speed DSP shown in figure 13 in that the high-speed DSP DMA request signal S1250 has a width equivalent to 2 clocks of the clock S1802 of the high-speed DSP 229. A DMA request signal is outputted from the DMA controller 125 to the DMA of the high-speed DSP 229. Further, as shown by the high-speed DSP DMA pipeline shown in figure 7, the high-speed computing unit 120 starts reception of the DMA at the rising edge of the DMA request signal, and receives the DMA at every other clock, in contrast to the conventional one. Then, the data are read from the data memory in the DSP after three clocks from the reception of the DMA.

In this construction, the ratio of clock frequencies of the low-speed DSP and the high-speed DSP is fixed to 1:2, and the DMA controller of the high-speed DSP is driven with the clock S2801 having a frequency that is 1/2 of the frequency of the clock S1802, whereby the data reading timing becomes the same time Tr for both the low-speed DSP 219 and the high-speed DSP 229, as shown in figure 6. Further, since the DMA request reception of the high-speed DSP 229 is enabled at every other clock as shown in figure 7, the DMA controller 115 and the DMA controller 125 can be completely common circuits.

In this second embodiment, in the low-speed and high-speed DSPs having the DMA latencies of "1 clock : 3 clocks", respectively, the ratio of the clock frequencies of the DSPs is set at "1:2". However, when generally expanding the DMA latency, the ratio of clock frequencies of the first processor and the second processor is "DMA latency of first processor + 1 : DMA latency of second processor + 1", and the computing unit that performs computation may ignore DMA reception by "(DMA latency 1)/2" times out of "(DMA latency + 1)/2" times.

The processor integrated circuit according to the second embodiment of the present invention is provided with the plural program memories 1311, 1312, 1313, and 1314 as memory areas, the plural data memories 1321, 1322, 1323, and 1324 as memory areas, and the selectors for selectively connecting the respective memory areas to either the low-speed computing unit or the high-speed computing unit. Therefore, it is possible to provide a processor integrated circuit which can reduce the memories by half, and can achieve both of securing in program compatibility and speeding-up, without increasing circuit scale and power consumption. Further, by combining the memory areas with the low-speed and the high-speed computing units, parallel computations can be carried out by the low-speed DSP and the high-speed DSP, thereby realizing further speeding-up of the processor integrated circuit.

Furthermore, the frame period of the low-speed DSP is four sample period and the frame period of the high-speed DSP is eight sample period, and the frame start of the high-speed DSP is synchronized with the frame start of the low-speed DSP, whereby handshaking between the low-speed processor and the high-speed processing can be dispensed with.

Further, the ratio of clock frequencies of the high-speed DSM DMA controller 125 and the high-speed DSP 229 is "1:2" to synchronize the data reading timings of the low-speed DSP 229 and the high-speed DSP 219, and further, the DMA request reception of the high-speed DSP 229 is enabled at every other clock. Therefore, the DMA controller 115 and the DMA controller 125 can be completely common circuits, thereby preventing an increase in man-hour in designing the DMA controller.

While the processor integrated circuit according to the second embodiment is constituted by a computing unit group including one high-speed computing unit and one low-speed computing unit, the present invention is not restricted thereto. The present invention is also effective even when using a computing unit group comprising n (n: natural number not less than 2) pieces of computing units among which at least one unit has a different architecture, or the n pieces of computing units may be identical computing units.

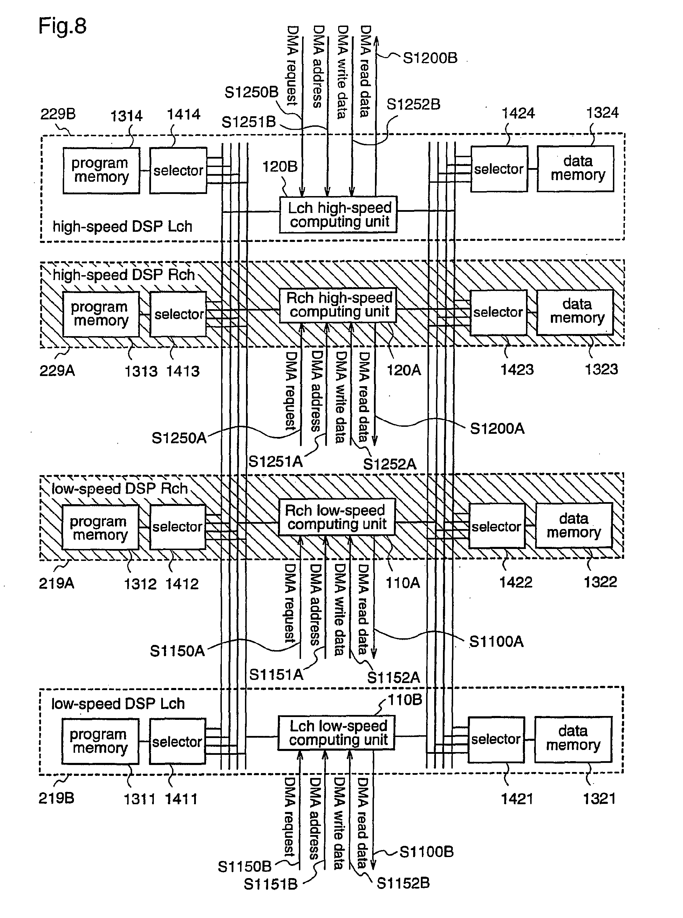

For example, as shown in figure 8, four computing units, i.e., two low-speed computing units 110A and 110B and two high-speed computing units 120A and 120B respectively for L-channel and R-channel are employed to constitute four DSPs, i.e., low-speed DSPs 219A and 219B and high-speed DSPs 229A and 229B, whereby four parallel computations can be carried out. At this time, by diving each of the two programs "audio compression" and "recording determination" into L-channel processing and R-channel processing, it is possible to obtain processing capability equivalent to 300MHz without increasing the number of memories, resulting in 6X-speed processing.

### (Embodiment 3)

As is generally known as "Moore's Law", miniaturization of semiconductor process has progressed year after year, and the price of LSI is getting down. Therefore, LSI process is progressed at each model change of AV equipment to achieve cost reduction.

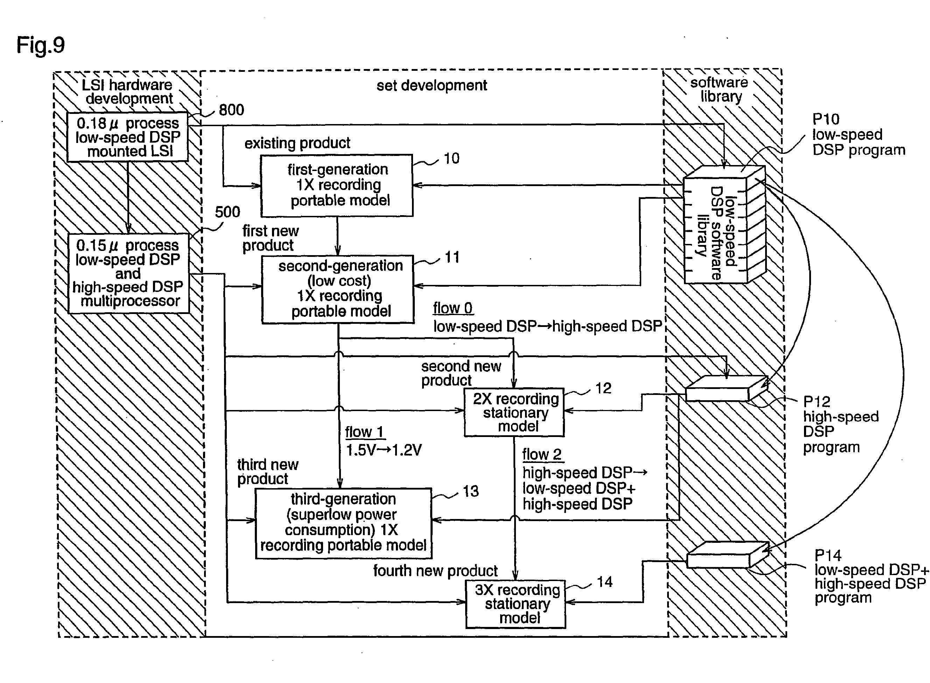

Figure 9 is a diagram illustrating a development flow of a new audio product using the processor integrated circuit 500 according to the second embodiment of the present invention.

In figure 9, an existing processor integrated circuit 800 which houses only a low-speed DSP that is operated with a program having usage track records is designed by a process of 0.18 micron pitch.

Further, the processor integrated circuit 500 is the processor integrated circuit described for the second embodiment, and it is deigned by a process of 0.15 micron pitch. In this third example, a computing unit group of the processor integrated circuit 500 comprises a low-speed computing unit 110 as a k-th computing unit which is operated by a program for operating the processor integrated circuit 800, and a high-speed computing unit 120 as a x-th computing unit having a processing capability higher than that of the k-th computing unit.

An existing audio product 10 using the processor integrated circuit 800 is a portable model that employs a low-speed DSP program P10, and performs 1X-speed recording of audio. The existing product 10 is constituted such that the conventional processor LSI 900 of the product shown in figure 11 is replaced with the processing integrated circuit 800, and in this third example, this product is regarded as a product to be a development base for four new products described later.

Next, new products 11, 12, 13, and 14 using the processor integrated circuit 500 will be described.

Figure 10 is a diagram illustrating usage modes, power supply voltages, and operating frequencies of the low-speed DSP 219 and the high-speed DSP 229 for each of the first, second, third, and fourth new produces in the flowchart shown in figure 9. Hereinafter, the third example will be described with reference to figures 9 and 10.

The first new product 11 as a product to be developed in a first product development process is a second generation portable model capable of recording at 1X speed, for which cost reduction is achieved by replacing the processor integrated circuit 800 of the existing product with the processor integrated circuit 500 of the present invention. At this time, all of the program memories 1311, 1312, 1313, and 1314 which are the first storage units having plural memory areas described with reference to figure 2 are connected to the low-speed computing unit 110 by the computing unit selectors 1411, 1412, 1413, and 1414 as the first switching units, and all of the data memories 1321, 1322, 1323, and 1324 as the second storage units having plural memory areas are connected to the low-speed computing unit 110 by the computing unit selectors 1421, 1422, 1423, and 1424 as the second switching units, whereby the low-speed DSP program P10 that has been used for the existing audio product 10 is operated as it is.

The second new product 12 as a product to be developed in a second product development process is a stationary model capable of recording at 2X speed (flow 0).

Initially, in the program change process (the first program change process), the low-speed DSP program P10 which is stored in the program memories 1311, 1312, 1313, and 1314 of the processor integrated circuit of the first new product 11 is changed to the high-speed DSP program P12 for operating the high-speed computing unit 120. In the first connection process, all of the program memories 1311, 1312, 1313, and 1314 as the first storage units shown in figure 2 are connected to the high-speed computing unit 120 by the computing selectors 1411, 1412, 1413, and 1414 as the first switching units. In the second connection process, all of the data memories 1321, 1322, 1323, and 1324 as the second storage units shown in figure 2 are connected to the high-speed computing unit 120 by the computing unit selectors 1421, 1422, 1423, and 1424 as the second switching units. Then, the high-speed DSP program is executed, thereby obtaining processing capability twice as high as that of the existing audio product 10 or the first new product 11.

As described above, since the same processor integrated circuit 500 is used for the first new product 11 and the second new product 12, the process of changing the low-speed DSP program P10 to the high-speed DSP program P12 can be carried out simultaneously with the mass-production process of the first new product 11, whereby the period of time required for the program change can be hidden. Further, there is no necessity of newly developing an LSI for the second new product 12.

The third new product 13 as a product to be developed in the third product development process is a third-generation low power consumption portable model which is capable of recording at 1X speed (flow 1).

In this third example, the third new product 13 employs the same program P12 as that for the second new product, and furthermore, the program memories 1311, 1312, 1313, and 1314 and the data memories 1321, 1322, 1323, and 1324 shown in figure 2 are connected to the high-speed computing unit 120 by the first connection process and the second connection process, like the second new product.

The power consumption of an LSI is proportional to the clock frequency, and to the second power of the power supply voltage. Further, when the power supply voltage is lowered, the wiring delay in the LSI increases and thereby the operation of the LSI usually stops, but the LSI can be operated with the clock frequency is reduced. So, in the power reduction process, the clock frequency to be supplied to the high-speed DSP 329 used for the third new product 13 is reduced to 1/2 of that for the processor integrated circuit of the second new product 12, whereby the power supply voltage can be lowered.

Therefore, although the DSP clock frequency is the same as that of the first new product 11, power consumption is reduced by 36% as compared with that of the first new product 11 by reducing the voltage of the LSI 200 from 1.5V to 1.2V. Further, since the same high-speed DSP program P12 as that for the second new product 12 can be used, there is no necessity of changing the program.

The fourth new product 14 as a product to be developed by the fourth product development process is a stationary model capable of recording at 3X speed (flow 2).

Initially, in the second program change process, the high-speed DSP program P12 stored in the program memories 1311, 1312, 1313, and 1314 of the processor integrated circuit of the second new product are changed to a dual DSP program P14 for making the low-speed computing unit 110 and the high-speed computing unit 120 perform parallel computing. In this third example, the dual DSP program P14 is, as described for figure 2, is a program obtained by changing the low-speed DSP program P10, and the processing to be performed by the low-speed DSP program P10 is divided into two programs of "audio compression" and "recording determination".

In the third connection process, as shown in figure 2, connection of the program memories 1311 and 1312 to the low-speed computing unit 110 and connection of the program memories 1313 and 1314 to the high-speed computing unit 120 are carried out by controlling the computing unit selectors 1411, 1412, 1413, and 1414. Further, in the fourth connection process, connection of the data memories 1321 and 1322 to the low-speed computing unit 110 and connection of the data memories 1323 and 1324 to the high-speed computing unit 120 are performed by controlling the computing unit selectors 1421, 1422, 1423, and 1424. When these connections are carried out to execute the dual DSP program P14, the low-speed computing unit and the high-speed computing unit can be made to perform parallel computations as a dual processor comprising the low-speed DSP 219 and the high-speed DSP 229, thereby obtaining processing capability three times as high as that of the existing audio product 10 or the first new product 11.

As described above, since the same processor integrated circuit 500 is used for the second new product 12 and the fourth new product 14, the process of changing the high-speed DSP processor P12 to the dual DSP program P14 can be carried out simultaneously with the mass-production process of the second new product, whereby the period of time required for program change can be hidden. Further, there is no necessity of newly developing a LSI for the fourth new product 14.

While in this third example an example of developing the fourth new product 14 from the second new product is described as defined in Claim 12, the fourth new product 14 may be developed immediately from the first new product 11 as defined in Claim 11. To be specific, when developing the fourth new product from the first new product, in the program change process as the second program change process of this third example, the low-speed DSP program P10 stored in the program memories is changed to the dual DSP program P14, and in the first connection process and the second connection process which are the third connection process and the fourth connection process of the third example, the program memories and the data memories are connected to the respective computing units to execute the dual DSP program P14. Since the same processor integrated circuit 500 is used for both of the first new product 11 and the fourth new product 14, the process of changing the low-speed DSP processor P10 to the dual DSP program P14 can be carried out simultaneously with the mass-production process of the first new product, whereby the period of time required for program change can be hidden.

It is needless to say that the fourth new product 14 can be developed from the third new product 13 which uses the same program as that for the second new product 12. Therefore, by using the same processor integrated circuit 500 for both of the third new product 13 and the fourth new product 14, the process of changing the high-speed DSP program P12 to the dual DSP program P14 can be carried out simultaneously with the mass-production process of the third new product 13, whereby the period of time required for program change can be hidden.

While in this third example the dual DSP program P14 used for the fourth new product is a program changed from the low-speed DSP program P10, it may be a program changed from the high-speed DSP program P12.

The processor integrated circuit described in the third example of the present invention can proceed development of low power consumption or high performance products in the same LSI, without requiring special LSIs for the first, second, third, and fourth product developments, respectively.

While in the product development method relating to the third example of the invention an example of developing products using the processor integrated circuit constituted by the low-speed and high-speed computing units shown in figure 2 has been described, a processor integrated circuit constituted by n (n: natural number not less than 2) pieces of computing units may be employed. For example, when using the processor integrated circuit comprising two low-speed DSPs and two high-speed DSPs as shown in figure 8, the fourth new product can be a stationary model capable of recording at 6X speed.

Further, while in this third example the processor integrated circuit 500 according to the second embodiment is used, the same effects as mentioned above can be achieved with respect to the first, second, and third products even when using the processor integrated circuit 100 according to the first example.

While in this third example product development is carried out using the existing product 10 as a base, the present invention is not restricted thereto. For example, product development may be carried out using the first new product as a base.

Further, while the second new product 13 and the fourth new product 14 according to the third example increase recording speed by higher performance, it is also possible to improve or change the function such as addition of sound quality correction and sound field processing or change to audio playback.

### APPLICABILITY IN INDUSTRY

A processor integrated circuit according to the present invention is a processor constituted on one chip LSI, and it is useful for enhancing performance of audio products while maintaining program compatibility. Further, it is applicable to video processing.

### It follows a list of further examples useful for understanding the invention:

### Example

1. A processor integrated circuit comprising:
   a computing unit group comprising two or more kinds of computing units;
   a first storage unit in which a program for operating the computing units is stored;
   a second storage unit as a memory area to be used for computation by the computing units;
   a first connection switching unit for connecting one computing unit performing computation which is included in the computing unit group, and the first storage unit;
   a second connection switching unit for connecting one computing unit performing computation which is included in the computing unit group, and the second storage unit;
   wherein computations by the computing units constituting the computing unit group are performed with the first and second storage units being shared among the computing units.

### Example

2. A processor integrated circuit with the features of example 1 wherein said computing unit group includes a computation unit that is operated with a program having usage track records.

### Example

3. A processor integrated circuit with the features of example 2 wherein said computing unit group includes a computing unit having processing capability higher than that of the computing unit that is operated with a program having usage track records.

### Example

4. A processor integrated circuit with the features of example 3 wherein said computing unit that is operated with a program having usage track records is smaller in power consumption than said computing unit having high processing capability.

### Example

5. A processor integrated circuit comprising:
   a computing unit group comprising two or more kinds of computing units;
   a first storage unit having plural memory areas, and storing one program or two or more programs for operating at least one of said computing units, in the plural memory areas;
   a second storage unit having plural memory areas to be used when at least one of the computing units performs computation;
   a first connection switching unit for connecting a computing unit performing computation which is included in the computing unit group, to memory areas of the first storage unit in which a program to be used by the competing unit is stored; and
   a second connection switching unit for connecting a computing unit performing computation which is included in the computing unit group, to the memory areas of the second storage unit;
   wherein, when performing parallel computations using the plural computing units, said first and second connection units control connections of the respective computing units to the respective memory areas of the first and second storage units, thereby performing parallel computations by the respective computing units, with the first and second storage units being shared among the respective computing units.

### Example

6. A processor integrated circuit with the features of example 5 wherein
   said first storage unit simultaneously stores plural programs to be executed by the respective computing units when the plural computing units perform parallel computations; and
   during execution of parallel computations, said first connection switching unit controls connections of the respective computing units and the respective memory areas of the first storage unit, thereby to connect the respective computing units performing parallel computations and the respective memory areas in which the plural programs are stored.

### Example

7. A processor integrated circuit with the features of example 5 wherein
   the respective computing units performing parallel computations start input/output of data with the same control signal; and
   the ratio of processing units of the input/output data is used as the ratio of program periods of the respective computing units, thereby to synchronize the respective computing units.

### Example

8. A processor integrated circuit comprising:
   n (n: natural number not less than 2) pieces of processors having different latencies of DMA (Direct Memory Access); and
   n pieces of DMA arbitration circuits for arbitrating accesses to the respective processors, and making DMA through computing units;
   wherein the ratio of clock frequencies of the respective processors is the ratio of (DMA latencies of the respective processors+1), and
   a computing unit that performs computation receives a first-time DMA request, and thereafter, nullifies a DMA request signal of (DMA latency-1) /2 times.

### Example

9. A product development method which is performed using a processor integrated circuit having a computing unit group comprising two or more kinds of computing units, said method comprising:
   a first product development process for developing a product using a k-th computing unit included in the computing unit group, said k-th computing unit being operated with a predetermined program that is stored in a first storage unit in which programs for operating the computing units are stored;
   a program changing process for changing the program which is stored in the first storage unit and corresponds to the k-th computing unit, to a program which operates an x-th computing unit included in the computing unit group, said x-th computing unit having processing capability higher than that of the k-th computing unit;
   a first connection process for connecting the x-th computing unit and the first storage unit;
   a second connection process for connecting the x-th computing unit and a second storage unit which is a memory area used by the k-th computing unit for computation; and
   a second product development process for executing said program using the x-th computing unit, thereby to develop a product having a performance higher than that of the product developed in the first product development process, or a product having a function different from that of the product developed in the first product development process.

### Example

10. A product development method which is performed by using a processor integrated circuit having a computing unit group comprising two or more kinds of computing units, said method comprising:
   a first product developing process for developing a product using a k-th computing unit included in the computing unit group, said k-th computing unit being operated with a predetermined program that is stored in a first storage unit in which programs for operating the computing units are stored;
   a program changing process for changing the program which is stored in the first storage unit and corresponds to the k-th computing unit, to a program which operates an x-th computing unit included in the computing unit group, said x-th computing unit having processing capability higher than that of the k-th computing unit;
   a first connection process for connecting the x-th computing unit and the first storage unit;
   a second connection process for connecting the x-th computing unit and a second storage unit which is a memory area used by the k-th computing unit for computation;
   a power reduction process for lowering a power supply voltage of the processor integrated circuit; and
   a third product development process for executing said program using the x-th computing unit, thereby to develop a product having the same performance or function as that of the product developed in the first product development process, and having reduced power consumption.

### Example

11. A product development method which is performed by using a processor integrated circuit having a computing unit group comprising two or more kinds of computing units, said method comprising:
   a first product developing process for developing a product using a k-th computing unit included in the computing unit group, said k-th computing unit being operated with a predetermined program that is stored in a first storage unit in which programs for operating the computing units are stored;
   a program changing process for changing the program which is stored in the first storage unit and corresponds to the k-th computing unit, to a program which makes two or more computing units perform parallel computations, said two or more computing units including at least the k-th computing unit and an x-th computing unit having processing capability higher than that of the k-th computing unit;
   a first connection process for connecting the two or more computing units and the first storage unit;
   a second connection process for connecting the two or more computing units and a second storage unit which is a memory area used by the k-th computing unit for computation; and
   a fourth product development process for executing said program using the two or more computing units including the k-th computing unit and the x-th computing unit, thereby to develop a product having a performance higher than that of the product developed in the first product development process, or a product having a function different from that of the product developed in the first product development process.

### Example

12. A product development method which is performed by using a processor integrated circuit having a computing unit group comprising two or more kinds of computing units, said method comprising:
   a first product developing process for developing a product using a k-th computing unit included in the computing unit group, said k-th computing unit being operated with a predetermined program that is stored in a first storage unit in which programs for operating the computing units are stored;
   a first program changing process for changing the program which is stored in the first storage unit and corresponds to the k-th computing unit, to a program which operates an x-th computing unit included in the computing unit group, said x-th computing unit having processing capability higher than that of the k-th computing unit;
   a first connection process for connecting the x-th computing unit and the first storage unit;
   a second connection process for connecting the x-th computing unit and a second storage unit which is a memory area used by the k-th computing unit for computation;
   a second product development process for executing said program using the x-th computing unit, thereby to develop a product having a performance higher than that of the product developed in the first product development process, or a product having a function different from that of the product developed in the first product development process;
   a second program changing process for changing the program which is stored in the first storage unit and corresponds to the x-th computing unit, to a program which makes two or more computing units perform parallel computations, said two or more computing units including at least the k-th computing unit and the x-th computing unit;
   a third connection process for connecting said two or more computing units and the first storage unit;
   a fourth connection process for connecting said two or more computing units and the second storage unit; and
   a fourth product development process for executing said program using said two or more computing units including the k-th computing unit and the x-th computing unit, thereby to develop a product having a performance higher than that of the product developed in the second product development process, or a product having a function different from that of the product developed in the second product development process.

## Claims

1. A processor integrated circuit (100) comprising:
n, n: natural number not less than 2, pieces of processors, each processor comprising:
- a computing unit (110,120) for doing DSP processing, and
- a memory (131,132) associated with the computing unit;
**characterized in**
n pieces of DMA arbitration circuits (115, 125) for arbitrating respective DMA accesses to the respective memories (131, 132) in the respective processors,
wherein the computing units (110, 120) further
have means for executing DMA read and write requests from the DMA arbitration circuits (115, 125) for transferring data between their respective memories (131, 132) and the outside of the processor integrated circuit (100),
have different latencies of DMA, wherein DMA latency is the number of clock cycles it takes from the time the DMA arbitration circuit (115, 125) outputs a DMA request to the computing unit (110, 120) until the computing unit (110, 120) outputs a DMA read signal to the DMA arbitration circuit (115, 125); and
wherein the ratio of clock frequencies of the respective processors is the ratio of (DMA latencies of the respective processors+1), and wherein
a computing unit (110, 120) that performs computation and that receives DMA requests ignores these DMA requests by (the computing unit's DMA latency-1)/2 times out of (the computing unit's DMA latency +1)/2 times.

## Patentansprüche

1. Integrierte Prozessorschaltung (100) mit:
n Prozessoren, wobei n eine natürliche Zahl nicht kleiner als 2 ist, wobei jeder Prozessor umfasst:
- eine Recheneinheit (110, 120) zum Ausführen von DSP-Verarbeitung und
- einen Speicher (131, 132), der mit der Recheneinheit assoziiert ist, **gekennzeichnet durch**:
n DMA-Verhandlungsschaltungen (115, 125) zum Verhandeln von jeweiligen DMA-Zugriffen auf jeweilige Speicher (131, 132) in jeweiligen Prozessoren, wobei die Recheneinheiten (110, 120) ferner
Mittel zum Ausführen von DMA-Lese- und Schreibanforderungen von den DMA-Verhandlungsschaltungen (115, 125) zum Übermitteln von Daten zwischen ihren jeweiligen Speichern (131, 132) und dem Äußeren der integrierten Prozessorschaltung (100) und
unterschiedliche DMA-Latenzen aufweisen, wobei eine DMA-Latenz die Anzahl von Taktzyklen ist, die von der Zeit, zu der die DMA-Verhandlungsschaltung (115, 125) eine DMA-Anforderung an die Recheneinheit (110, 120) ausgibt, bis zu der Zeit benötigt werden, zu der die Recheneinheit (110, 120) ein DMA-Lesesignal an die DMA-Verhandlungsschaltung (115, 125) ausgibt, und
wobei das Verhältnis von Taktfrequenzen der jeweiligen Prozessoren das Verhältnis von (DMA-Latenzen der jeweiligen Prozessoren +1) ist, und wobei
eine Recheneinheit (110, 120) die eine Berechnung durchführt und die DMA-Anforderungen empfängt, diese DMA-Anforderungen in (DMA-Latenz der Recheneinheit -1)/2 Malen aus (DMA-Latenz der Recheneinheit +1)/2 Malen ignoriert.

## Revendications

1. Circuit intégré de processeur (100) comprenant :
n, n : nombre naturel non inférieur à 2, unités de processeurs, chaque processeur comprenant :
- une unité de calcul (110, 120) pour effectuer un traitement DSP, et
- une mémoire (131, 132) associée avec l'unité de calcul ;
**caractérisé par**
n unités de circuits d'arbitrage DMA (115, 125) pour arbitrer des accès DMA respectifs aux mémoires (131, 132) respectives dans les processeurs respectifs,
dans lequel les unités de calcul (110, 120) en outre
ont un moyen d'exécution de requêtes de lecture et d'écriture DMA provenant des circuits d'arbitrage DMA (115, 125) pour un transfert de données entre leurs mémoires (131, 132) respectives et l'extérieur du circuit intégré de processeur (100),
ont différentes latences de DMA, dans lequel une latence de DMA est le nombre de cycles d'horloge nécessaires de l'instant où le circuit d'arbitrage DMA (115, 125) délivre en sortie une requête DMA à l'unité de calcul (110, 120) jusqu'à ce que l'unité de calcul (110, 120) délivre en sortie un signal de lecture DMA au circuit d'arbitrage DMA (115, 125) ; et
dans lequel le rapport de fréquences d'horloge des processeurs respectifs est le rapport (latences de DMA des processeurs respectifs + 1), et dans lequel
une unité de calcul (110, 120) qui effectue un calcul et qui reçoit des requêtes DMA ignore ces requêtes DMA (la latence de DMA de l'unité de calcul - 1)/2 fois sur (la latence de DMA de l'unité de calcul + 1)/2 fois.
